# EUROPEAN PATENT APPLICATION

(11) **EP 4 832 294 A1**
(43) Date of publication of application: **28.10.2026**
(21) Application number: 24892632.1
(22) Date of filing: 28.03.2024
(51) Int. Cl.: H02J 7/00, H02H 7/18

(54) **MEASUREMENT AND CONTROL MODULE FOR INTELLIGENT CHARGING AND DISCHARGING, AND CHARGING AND DISCHARGING SYSTEM USING MODULE**

(30) Priority: 20.11.2023 CN 202311550964
(71) Applicant: Meizhou Jiangnan Electric Appliance Co., Ltd., Meizhou, Guangdong 514000 (CN)
(72) Inventor: CHEN, Zhifeng, Meizhou, Guangdong 514000 (CN); CHEN, Chao, Meizhou, Guangdong 514000 (CN); CHEN, Ting, Meizhou, Guangdong 514000 (CN); LI, Wanmin, Meizhou, Guangdong 514000 (CN); SONG, Xuer, Meizhou, Guangdong 514000 (CN); LI, Shulan, Meizhou, Guangdong 514000 (CN)
(74) Representative: Cabinet Chaillot
(86) International application number: PCT/CN2024/084274
(87) International publication number: WO 2025/107465

(57) **Abstract**

The present invention relates to the technical field of new energy. Disclosed are a measurement and control module for intelligent charging and discharging, and a charging and discharging system using the module. The measurement and control module comprises measurement and control boards, each measurement and control board is in circuit connection with an automatic switching element and a battery to be measured, the automatic switching element is arranged on a main connecting wire of the battery and is connected to a power supply, and a bypass circuit that bypasses the corresponding battery to be measured is connected between the automatic switching element and the main connecting wire. The present invention aims to provide a measurement and control module for intelligent charging and discharging that has a compact and ingenious structure, is easy to use and has good effects, and a charging and discharging system using the module. The present invention is applied to new energy.

## Description

### Technical Field

The invention belongs to the technical field of measurement and control modules, in particular to a measurement and control module for intelligent charging and discharging, and a charging and discharging system using the module.

### Background Art

Currently, with the continuous popularity of new energy vehicles and energy storage systems that utilize power batteries, safety issues and the shortcomings of power batteries are becoming increasingly prominent. Additionally, the number of old power batteries is rapidly increasing, making the recycling and disposal of these batteries an urgent issue. The government encourages enterprises to carry out cascaded utilization of power batteries, among which using old power batteries for energy storage is the most significant yet challenging aspect. This is due to the diversity in brands and specifications of old power batteries, as well as their varying performances. If they are to be used for energy storage, it is necessary to test and screen each old power battery, which requires a considerable amount of manpower and resources, resulting in high energy storage costs. More importantly, the probability of old power batteries experiencing failures and even thermal runaway is much higher than that of new power batteries. If this safety risk cannot be addressed, old power batteries cannot be safely used for energy storage.

### Summary of the Invention

One objective of this invention is to address the shortcomings of the prior art by providing a compact, ingenious, easy-to-use, and effective measurement and control module for intelligent charging and discharging.

The other objective of this invention is to provide a charging and discharging system using the module.

The preceding technical solution of this invention is implemented as follows: a measurement and control module for intelligent charging and discharging, comprising measurement and control boards, each measurement and control board is in circuit connection with an automatic switching element and a battery to be measured, the automatic switching element is arranged on a main connecting wire of the battery to be measured, the automatic switching element is connected to a power supply, a bypass circuit that bypasses the corresponding battery to be measured is connected between the automatic switching element and the main connecting wire, the measurement and control board directly detects and acquires the voltage and temperature of the battery to be measured.

In the above measurement and control module for intelligent charging and discharging, the measurement and control board is connected to the battery to be measured via two voltage detection wires, the two voltage detection wires are connected to positive and negative terminals of the battery to be measured, respectively.

In the above measurement and control module for intelligent charging and discharging, the measurement and control board comprises a main control circuit, the main control circuit is respectively connected to a communication circuit and a voltage sampling circuit, the communication circuit is connected to an external control system, the voltage sampling circuit is connected to the battery to be measured.

In the above measurement and control module for intelligent charging and discharging, the main control circuit is connected to an actuating element, the actuating element is located between the automatic switching element and the power supply.

In the above measurement and control module for intelligent charging and discharging, the main control circuit is connected to a temperature measurement circuit, and a temperature probe of the temperature measurement circuit is positioned on the battery to be measured.

In the above measurement and control module for intelligent charging and discharging, the measurement and control board is provided with a step-down circuit; an input terminal of the step-down circuit is connected to the power supply, and an output terminal is respectively connected to various low-voltage electrical components.

In the above measurement and control module for intelligent charging and discharging, an isolated step-down circuit and an isolation element are sequentially connected between the power supply and the step-down circuit, the isolation element is located between the battery to be measured and the voltage sampling circuit.

The following technical solution of this invention is implemented as follows: a charging and discharging system, comprising at least one set of battery pack and electrical equipment that is connected to the battery pack in a one-to-one correspondence, each battery pack is composed of several batteries or battery modules connected in series, both ends of each battery or battery module are connected to the corresponding measurement and control board through the voltage detection wires, the automatic switching element is placed on the main connecting wire outside one of the voltage detection wires of each battery or battery module, the automatic switching element is connected to the measurement and control board; each measurement and control board is respectively connected to a control terminal.

In the above charging and discharging system, the battery pack is connected in series with a backup battery pack for voltage stabilization, and the backup battery pack is connected to the control terminal.

In the above charging and discharging system, the electrical equipment is sequentially connected to a first current transformer, a second current transformer, and a transformer, the transformer is connected to an external power supply, the first current transformer is connected to a metering meter, the second current transformer is connected to a control meter, the metering meter and the control meter are respectively connected to the control terminal, the first current transformer and the second current transformer are each installed on the circuit.

By adopting the aforementioned structure, the invention utilizes measurement and control boards that correspond one-to-one with each battery, allowing for independent detection of battery parameters; additionally, the automatic switching elements controlled by the measurement and control boards are also set up in a one-to-one configuration with the batteries; this enables quick and accurate independent control of each individual battery during the charging and discharging processes, facilitating their connection to the system or disconnection for operation; this effectively prevents dangers caused by overcharging, over-discharging, and overheating of the batteries; furthermore, it ensures the safety of each battery during the charging and discharging process while also extending the lifespan of the batteries.

### Brief Description of Accompanying Drawings

The invention will be further described in detail below with reference to the embodiments shown in the accompanying drawings, but this does not constitute any limitation on the invention.
FIG. 1 is a block diagram of Embodiment 1 of the measurement and control module of the invention;
FIG. 2 is a block diagram of the measurement and control module of the invention using the battery as the power supply for the isolation element;
FIG. 3 is a block diagram of Embodiment 2 of the measurement and control module of the invention;
FIG. 4 is a block diagram of the external relay of the measurement and control board in the centralized charging and discharging system of the invention;
FIG. 5 is a schematic diagram of the connection structure between the battery pack and the backup battery pack of the invention;
FIG. 6 is a block diagram of the built-in relay of the measurement and control board in the centralized charging and discharging system of the invention.

In the figures: 1 measurement and control board; 1a main control circuit; 1b communication circuit; 1c voltage sampling circuit; 1d actuating element; 1e temperature measurement circuit; 1f step-down circuit; 1g isolated step-down circuit; 1h isolation element; 2 automatic switching element; 3 main connecting wire; 4 power supply; 5 bypass circuit; 6 voltage detection wire; 7 battery pack; 8 electrical equipment; 9 control terminal; 10 backup battery pack; 11 first current transformer; 12 second current transformer; 13 transformer; 14 metering meter; 15 control meter.

### Specific Embodiment of the invention

### Embodiment 1

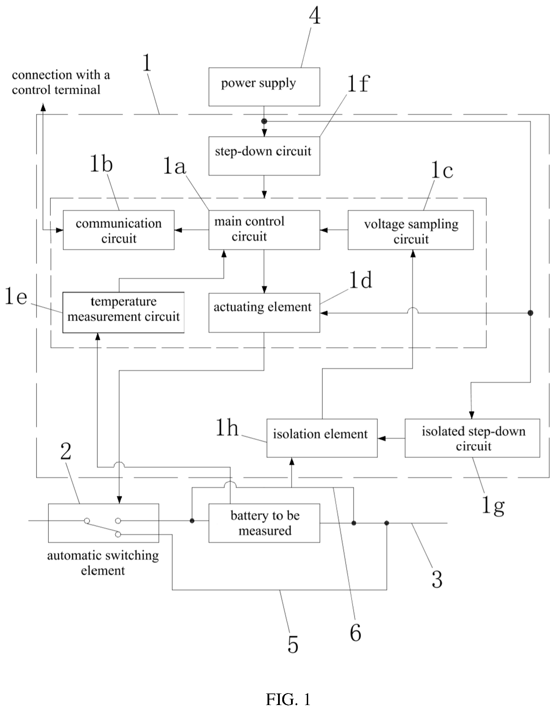

Referring to FIG. 1, a measurement and control module for intelligent charging and discharging provided by the invention, comprising measurement and control boards 1, each measurement and control board 1 is in connection with an automatic switching element 2 and a battery to be measured, the automatic switching element 2 is arranged on a main connecting wire 3 of the battery to be measured, and it can be located either in front of or behind the battery to be measured. The automatic switching element 2 is connected to a power supply 4, a bypass circuit 5 that bypasses the corresponding battery to be measured is connected between the automatic switching element 2 and the main connecting wire 3, the measurement and control board 1 directly detects and acquires the voltage and temperature of the battery to be measured. Specifically, two voltage detection wires 6 are set up between the measurement and control board 1 and the battery to be measured, the two voltage detection wires 6 are connected to the positive and negative terminals of the battery to be measured, respectively. The arrangement of the bypass circuit, combined with the presence of voltage detection wires on both sides of each battery to be measured, allows the measurement and control board to directly acquire the voltage and temperature parameters of the corresponding battery nearby; this facilitates close control of each battery and enables data feedback to the external control terminal, allowing for independent auxiliary control of each battery to be measured by the terminal. The connection or disconnection of each battery will not affect the other batteries.

More crucially, the measurement and control board can directly detect and obtain battery parameters in close proximity and has the authority to directly control the corresponding battery's exit from the system. This greatly ensures the safety of the system's operation, preventing situations where communication failures between the measurement and control board and the upper-level control terminal or data processing terminal could hinder timely control of the batteries, potentially leading to safety incidents.

At the same time, the batteries that exit the charging and discharging system remain under real-time monitoring by the control terminal; if the control terminal detects any anomalies with a particular battery to be measured, the system will issue an alarm or shut down based on the actual situation to prevent potential dangers.

During the charging and discharging process, even if issues arise with the control terminal or communication lines are interrupted, it will not lead to overcharging or over-discharging of the batteries to be measured, thus avoiding hazards. This approach, compared with existing technologies, effectively enables independent management and control of individual batteries, ensuring they do not overcharge, over-discharge, or overheat while maintaining their original performance status. This significantly mitigates the safety risks associated with using new batteries, especially older batteries, for energy storage or electric vehicles. The independent management of each battery allows for a "first fully charged, first to exit" during charging, and a "first depleted, first to exit" during discharging, effectively addressing the shortcomings effect.

Additionally, to enhance integration and facilitate wiring and installation, the automatic switching element is also configured to be integrated into the measurement and control board. Compared with the above separate structure, this represents an equivalent alternative solution that would be easily conceived by skilled professionals in the field.

In this embodiment, the measurement and control board 1 comprises a main control circuit 1a, the main control circuit 1a is respectively connected to a communication circuit 1b and a voltage sampling circuit 1c, the communication circuit 1b is connected to an external control system, the voltage sampling circuit 1c is connected to the battery to be measured. The measurement and control board 1 is provided with a step-down circuit 1f; an input terminal of the step-down circuit 1f is connected to the power supply 4, and an output terminal is respectively connected to various low-voltage electrical components, providing power to these components. The power supply for the measurement and control board is preferably sourced from an external power supply; of course, theoretically, it could also be powered by the battery being measured. Nevertheless, if there are issues with the battery, the measurement and control board will not function properly. Therefore, the preferred option is to use an external power supply for powering the unit.

Preferably, the main control circuit 1a is connected to an actuating element 1d, the actuating element 1d is located between the automatic switching element 2 and the power supply 4. Of course, when the automatic switching element uses electronic components such as interlocking MOSFETs ((Metal Oxide Semiconductor Field Effect Transistor), action components are not required. However, when the automatic switching element employs relays, action components are necessary. In this embodiment, the automatic switching element utilizes relays, which offer advantages such as safety, stability, and high reliability.

Preferably, the main control circuit 1a is connected to a temperature measurement circuit 1e, and a temperature probe of the temperature measurement circuit 1e is positioned on the battery to be measured. The temperature of the battery to be measured is monitored in real time through a temperature sensing circuit. This is primarily considered because if the battery to be measured is an older battery, its performance and quality are unstable, leading to a higher failure rate compared with new batteries. By increasing temperature detection, the safety performance can be further enhanced. Of course, when the battery to be measured is a new power battery, this system is still applicable and can continue to improve the overall safety of the system.

In this embodiment, an isolated step-down circuit 1g and an isolation element 1h are sequentially connected between the power supply 4 and the step-down circuit 1f, the isolation element 1h is located between the battery to be measured and the voltage sampling circuit 1c. By using the isolation element to disconnect the voltage sampling circuit, the high voltage resulting from the series connection of the batteries to be measured is prevented from damaging the measurement and control board and the power supply. This structure is primarily suitable for high-voltage charging and discharging systems involving multiple batteries in series, typically those with charging and discharging voltages exceeding several hundred volts.

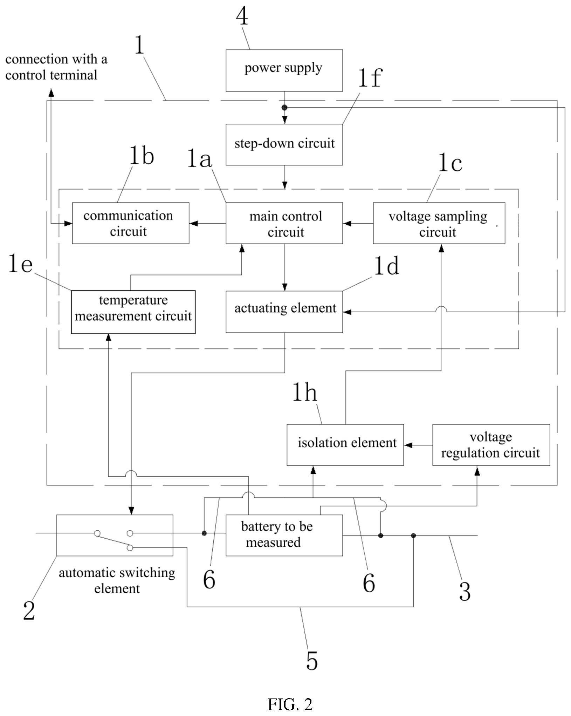

Additionally, when the isolation element is used, it is also configured to be powered by the battery to be measured. In this case, the module does not require an isolation step-down circuit; instead, a voltage regulation circuit should be added between the battery to be measured and the isolation element. This is specifically illustrated in Figure 2.

It is important to emphasize that with technological advancements, the integration level of various functional circuits will change accordingly. Multiple functional circuits may be integrated onto a single chip or distributed across several complementary chips. Furthermore, the entire functionality of the measurement and control board is also configured to be integrated into the automatic switching element, forming a functional module similar to an IGBT (Insulated Gate Bipolar Transistor). These are all equivalent alternative solutions that skilled professionals in the field can easily conceive as technology continues to evolve.

### Embodiment 2

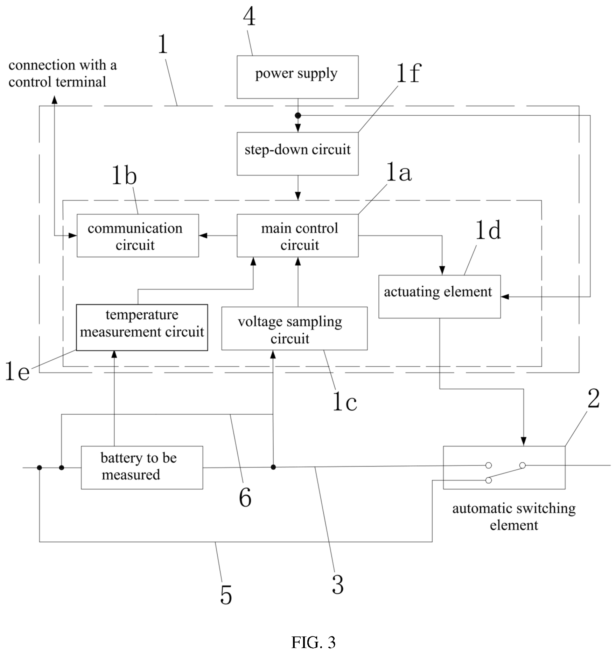

Referring to FIG. 3, a measurement and control module for intelligent charging and discharging provided by the invention has a structure that is essentially the same as that of Embodiment 1, with the difference being that the module does not comprises isolation element or corresponding isolated step-down circuit, and it is only suitable for low-voltage applications with a small number of batteries connected in series, such as charging and discharging systems below 100V.

### Embodiment 3

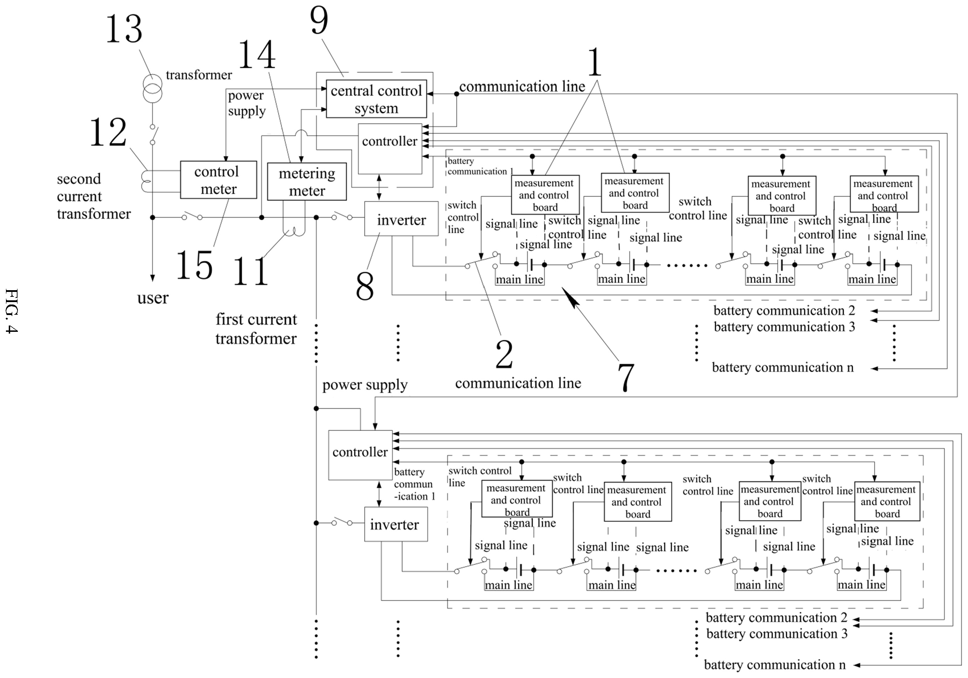

Referring to FIG. 4, a charging and discharging system using the module provided by the invention comprises at least one set of battery pack 7 and electrical equipment 8 that is connected to the battery pack 7 in a one-to-one correspondence, each battery pack 7 is composed of several batteries or battery modules connected in series, both ends of each battery or battery module are connected to the corresponding measurement and control board 1 through the voltage detection wires 6, the automatic switching element 2 is placed on the main connecting wire 3 outside one of the voltage detection wires 6 of each battery or battery module, the automatic switching element 2 is connected to the measurement and control board 1; each measurement and control board 1 is respectively connected to a control terminal 9. For ease of control, the control terminal is preferably composed of a central control system and controllers connected to each battery pack. The number of battery packs that can be controlled is determined by the controllers. When there are many battery packs, the controllers are connected in parallel to the central control system. Of course, when the system is smaller, the controllers can also be used directly for control.

The measurement and control board conducts voltage and temperature detection on each cell or battery module nearby, which can save a significant amount of wiring and reduce costs. At the same time, the measurement and control board can autonomously shut down the controlled battery based on preset voltage or temperature levels. Specifically, within a single operating cycle, such as one charging cycle or one discharging cycle, the measurement and control board can only perform a shutdown operation on the battery once. Once shut down, the battery cannot be reconnected to the system by the measurement and control board; it must be controlled by the control terminal. This serves as a first layer of safety protection for the system. By controlling the batteries locally, the measurement and control board can effectively avoid delays in processing caused by communication failures or delays with the higher-level unit.

The control terminal is equipped with warning voltage values and shutdown voltage values, which can provide a second and third layer of safety protection in case the measurement and control board malfunctions.

In this embodiment, when the system is applied in new energy scenarios, it requires AC/DC conversion, and the electrical equipment needs to be connected to an inverter for conversion.

When the system is applied to electric vehicles, it can be directly connected to the electrical equipment based on actual conditions.

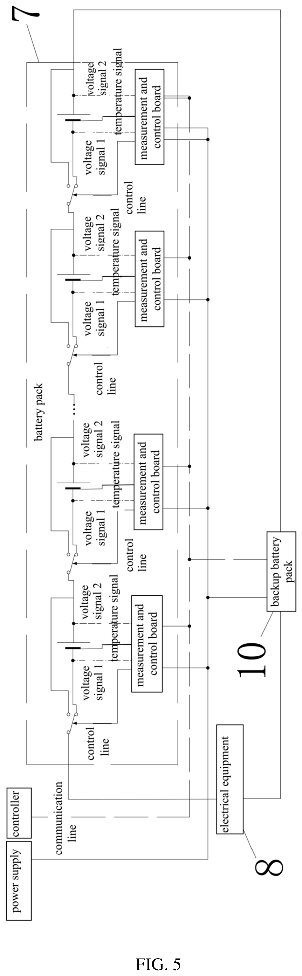

Preferably, as shown in FIG. 5, the battery pack 7 is connected in series with a backup battery pack 10 for voltage stabilization, and the backup battery pack 10 is connected to the control terminal 9. By setting up the backup battery pack, the stability of the output voltage can be ensured. Furthermore, it is preferred that the structure of the backup battery pack is the same as that of the battery pack in the charging and discharging system, and both need to be independently controlled by separate measurement and control boards. Automatic switching element should also be installed on the circuit. When the system first starts operating, the backup battery pack remains in a bypass state, meaning it does not participate in the output. After the system has been running for a period of time and the battery pack voltage decreases, the backup battery pack is activated based on the preset voltage value, thereby ensuring that the system voltage remains relatively constant. This avoids increased current output due to voltage drops, ensuring the system operates safely during a long period.

Without the backup battery pack, the system can only increase the current to maintain the output power, which may result in high current discharges from the batteries, damaging them and reducing their lifespan.

Further, to achieve precise control of the output power to electrical equipment based on changes in the load of user equipment, while also enabling real-time monitoring of the operational status of the new energy system, the electrical equipment 8 is sequentially connected to a first current transformer 11, a second current transformer 12, and a transformer 13, the transformer 13 is connected to an external power supply, the first current transformer 11 is connected to a metering meter 14, the second current transformer 12 is connected to a control meter 15, the metering meter 14 and the control meter 15 are respectively connected to the control terminal 9, the first current transformer 11 and the second current transformer 12 are each installed on the circuit.

Based on user demand, specifically the electricity needs of the electrical equipment, the number of battery packs can be specifically set. Each battery pack is provided with corresponding electrical equipment and controllers, with the electrical equipment connected to the controllers. The controllers then manage multiple parallel battery packs, then the controllers are connected to a central control system. The electrical equipment within each battery pack are connected in parallel, then connected to the central control system. For smaller systems, a central control system may not be necessary, and the controllers are configured to directly manage several electrical equipment and multiple battery packs.

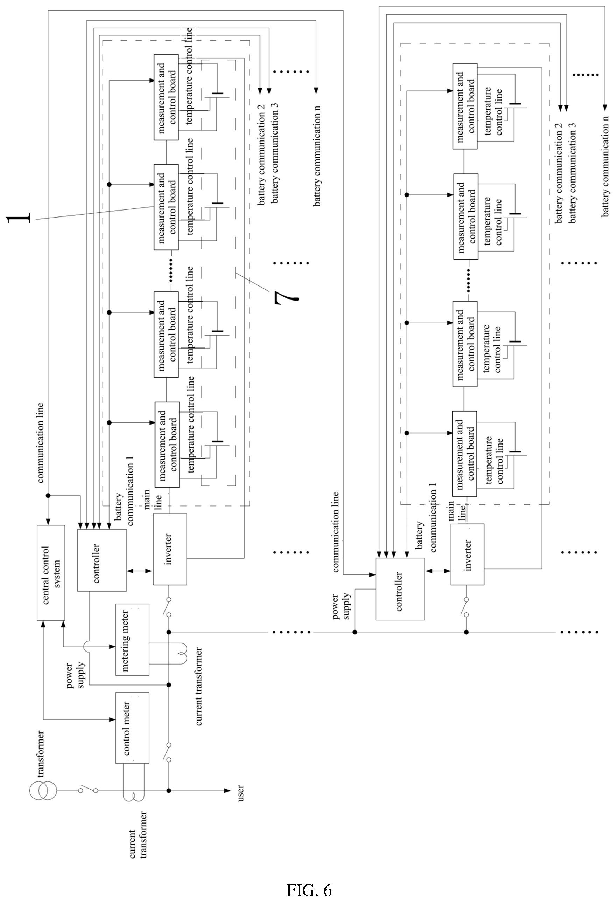

Additionally, as shown in FIG. 6, when the automatic switching element is flexibly integrated into the measurement and control board in the measurement and control module, the wiring can be significantly simplified, making maintenance easier. This is also an equivalent alternative that can be easily conceived by those skilled in the art based on the concepts of this invention.

The above embodiments are preferred embodiments of the invention and are used only to facilitate the illustration of the invention. They are not intended to limit the invention in any way. Any equivalent embodiments made by those skilled in the art, utilizing the technical content provided in the invention with partial modifications or alterations, without departing from the technical features of the present invention, shall still fall within the scope of the technical features of the invention.

## Claims

1. A measurement and control module for intelligent charging and discharging, comprising measurement and control boards (1), wherein each measurement and control board (1) is in circuit connection with an automatic switching element (2) and a battery to be measured, the automatic switching element (2) is arranged on a main connecting wire (3) of the battery to be measured, the automatic switching element (2) is connected to a power supply (4), a bypass circuit (5) that bypasses the corresponding battery to be measured is connected between the automatic switching element (2) and the main connecting wire (3), the measurement and control board (1) directly detects and acquires the voltage and temperature of the battery to be measured.

2. The measurement and control module for intelligent charging and discharging of claim 1, wherein the measurement and control board (1) is connected to the battery to be measured via two voltage detection wires (6), the two voltage detection wires (6) are connected to positive and negative terminals of the battery to be measured, respectively.

3. The measurement and control module for intelligent charging and discharging of claim 1, wherein the measurement and control board (1) comprises a main control circuit (1a), the main control circuit (1a) is respectively connected to a communication circuit (1b) and a voltage sampling circuit (1c), the communication circuit (1b) is connected to an external control system, the voltage sampling circuit (1c) is connected to the battery to be measured.

4. The measurement and control module for intelligent charging and discharging of claim 3, wherein the main control circuit (1a) is connected to an actuating element (1d), the actuating element (1d) is located between the automatic switching element (2) and the power supply (4).

5. The measurement and control module for intelligent charging and discharging of claim 3, wherein the main control circuit (1a) is connected to a temperature measurement circuit (1e), and a temperature probe of the temperature measurement circuit (1e) is positioned on the battery to be measured.

6. The measurement and control module for intelligent charging and discharging of claim 3, wherein the measurement and control board (1) is provided with a step-down circuit (1f); an input terminal of the step-down circuit (1f) is connected to the power supply (4), and an output terminal is respectively connected to various low-voltage electrical components.

7. The measurement and control module for intelligent charging and discharging of claim 6, wherein an isolated step-down circuit (1g) and an isolation element (1h) are sequentially connected between the power supply (4) and the step-down circuit (1f), the isolation element (1h) is located between the battery to be measured and the voltage sampling circuit (1c).

8. A charging and discharging system, using the module as described in any one of claims 2-7, comprising at least one set of battery pack (7) and electrical equipment (8) that is connected to the battery pack (7) in a one-to-one correspondence, wherein each battery pack (7) is composed of several batteries connected in series, both ends of each battery are connected to the corresponding measurement and control board (1) through the voltage detection wires (6), the automatic switching element (2) is placed on the main connecting wire (3) outside one of the voltage detection wires (6) of each battery or battery module, the automatic switching element (2) is connected to the measurement and control board (1); each measurement and control board (1) is respectively connected to a control terminal (9).

9. The charging and discharging system of claim 8, wherein the battery pack (7) is connected in series with a backup battery pack (10) for voltage stabilization, and the backup battery pack (10) is connected to the control terminal (9).

10. The charging and discharging system of claim 8, wherein the electrical equipment (8) is sequentially connected to a first current transformer (11), a second current transformer (12), and a transformer (13), the transformer (13) is connected to an external power supply, the first current transformer (11) is connected to a metering meter (14), the second current transformer (12) is connected to a control meter (15), the metering meter (14) and the control meter (15) are respectively connected to the control terminal (9), the first current transformer (11) and the second current transformer (12) are each installed on the circuit.
